# EUROPEAN PATENT APPLICATION

(11) **EP 4 686 356 A1**
(43) Date of publication of application: **28.01.2026**
(21) Application number: 24775167.0
(22) Date of filing: 19.03.2024
(51) Int. Cl.: H10K 50/16, H10K 50/818, H10K 50/82, H10K 50/165, H10K 50/15, H10K 59/123

(54) **LIGHT-EMITTING DIODE AND DISPLAY DEVICE COMPRISING SAME**

(30) Priority: 20.03.2023 KR 20230036025; 09.02.2024 US 202418437551; 12.03.2024 CN 202410278053
(71) Applicant: Samsung Display Co., Ltd., Yongin-si, Gyeonggi-do 17113 (KR)
(72) Inventor: JUNG, Yun Ku, Yongin-si, Gyeonggi-do 17113 (KR); KO, Yunhyuk, Yongin-si, Gyeonggi-do 17113 (KR); KIM, Sehun, Yongin-si, Gyeonggi-do 17113 (KR); KIM, Jonghoon, Yongin-si, Gyeonggi-do 17113 (KR); NOH, Seung Uk, Yongin-si, Gyeonggi-do 17113 (KR); PARK, Won-Jun, Yongin-si, Gyeonggi-do 17113 (KR); PARK, Chul Soon, Yongin-si, Gyeonggi-do 17113 (KR); SHIN, Jongwoo, Yongin-si, Gyeonggi-do 17113 (KR); LEE, Sooho, Yongin-si, Gyeonggi-do 17113 (KR); HA, Jae Kook, Yongin-si, Gyeonggi-do 17113 (KR)
(74) Representative: Marks & Clerk LLP
(86) International application number: PCT/KR2024/003416
(87) International publication number: WO 2024/196119

(57) **Abstract**

A light emitting device includes: a first electrode that is a reflective electrode; a first electron transport layer disposed on the first electrode; a second electron transport layer disposed on the first electron transport layer; an emission layer disposed on the second electron transport layer; and a second electrode positioned on the emission layer and that is a transflective electrode, wherein the first electron transport layer and the second electron transport layer include different metal oxides, and a thickness of the first electron transport layer is greater than a thickness of the second electron transport layer.

## Description

### BACKGROUND

### 1. Technical Field

Embodiments relate to a light-emitting device and a display device including the light-emitting device.

### 2. Description of the Related Art

A light emitting device includes an anode, a cathode, and an emission layer formed between the anode and the cathode. Excitons are generated by combination of holes injected from the anode and electrons injected from the cathode in the emission layer, and light is generated by the excitons, which are transitioned from an excited state to a ground state.

The light emitting device may be driven by a low voltage and may be lightweight and thin, and may have excellent characteristics such as a viewing angle, contrast, and a response speed, and thus an application range is expanding from personal portable devices to televisions.

### SUMMARY

Embodiments provide a light emitting device capable of improving device characteristic by including a multi-layered electron transport layer and a display device including the light emitting device.

An embodiment provides a light emitting device including: a first electrode that is a reflective electrode; a first electron transport layer disposed on the first electrode; a second electron transport layer disposed on the first electron transport layer; an emission layer disposed on the second electron transport layer; and a second electrode positioned on the emission layer and that is a transflective electrode, wherein the first electron transport layer and the second electron transport layer include different metal oxides, and a thickness of the first electron transport layer is greater than a thickness of the second electron transport layer.

The first electron transport layer may include at least one of ZnO, TiO₂, WO₃, and SnO₂ and/or at least one of ZnO, TiO₂, WO₃, and SnO₂ doped with Mg, Y, Li, Ga, and Al.

The second electron transport layer may include at least one of ZnO, TiO₂, WO₃, and SnO₂ and/or at least one of ZnO, TiO₂, WO₃, and SnO₂ doped with Mg, Y, Li, Ga, and Al.

The thickness of the first electron transport layer may be in a range of about 85 nm to about 250 nm.

The thickness of the second electron transport layer may be in a range of about 20 nm to about 40 nm.

An electron mobility of the first electron transport layer may be faster than an electron mobility of the second electron transport layer.

An electron mobility of the first electron transport layer may be about 5 x 10⁻³ cm²V⁻¹S⁻¹ to about 5 x 10⁻⁵ cm²V⁻¹S⁻¹.

An electron mobility of the second electron transport layer may be about 1 x 10⁻³ cm²V⁻¹S⁻¹ to about 1 x 10⁻⁵ cm²V⁻¹S⁻¹ .

Light emitted from the emission layer may be subjected to secondary resonance between the first electrode and the second electrode.

A thickness of the emission layer may be in a range of about 10 nm to about 30 nm.

It may further include a hole transport layer disposed between the emission layer and the second electrode, and a thickness of the hole transport layer may be in a range of about 10 nm to about 30 nm.

The first electron transport layer may include ZnO, and the second electron transport layer may include ZnMgO.

An embodiment provides a display device including: a plurality of transistors positioned on a substrate; and a plurality of light emitting devices connected to the respective transistors, wherein the light emitting devices include a first light emitting device, a second light emitting device, and a third light emitting device, each of the plurality of light emitting devices may include: a first electrode connected to the transistors; a first electron transport layer disposed on the first electrode; a second electron transport layer disposed on the first electron transport layer; an emission layer disposed on the second electron transport layer; and a hole transport layer disposed on the emission layer; and a second electrode disposed on the hole transport layer, the first electron transport layer and the second electron transport layer include different metal oxides, and a thickness of the first electron transport layer is greater than a thickness of the second electron transport layer.

The first electron transport layer may include at least one of ZnO, TiO₂, WO₃, and SnO₂ and/or at least one of ZnO, TiO₂, WO₃, and SnO₂ doped with Mg, Y, Li, Ga, and Al.

The first light emitting device may be configured to emit red light, and the thickness of the first electron transport layer included in the first light emitting device may be in a range of about 85 nm to about 250 nm. The second light emitting device may may be configured to emit blue light, and the thickness of the first electron transport layer of the first light emitting device may be greater than the thickness of the first electron transport layer of the second light emitting device.

The thickness of the second electron transport layer may be in a range of about 20 nm to about 40 nm.

An electron mobility of the first electron transport layer may be faster than an electron mobility of the second electron transport layer.

The first electron transport layer may include ZnO, and the second electron transport layer may include ZnMgO.

The first electrode may be a reflective electrode, and the second electrode may be a transflective electrode.

According to embodiments, it is possible to provide a light emitting device having an improved device characteristic by including a multi-layered electron transport layer and a display device including the light-emitting device.

### BRIEF DESCRIPTION OF THE DRAWINGS

FIG. 1 illustrates a schematic cross-section of a light emitting device according to an embodiment.
FIGS. 2, 3, 4, and 5 illustrate an electron transport layer according to Experimental Examples 1 to 4.
FIG. 6 illustrates a V-J graph of Experimental Examples 1 to 4.
FIG. 7 illustrates efficiencies of Experimental Examples 1 to 4.
FIG. 8 illustrates an efficiency according to a thickness of a first electron transport layer including ZnO in a light emitting device emitting red light.
FIG. 9 illustrates an efficiency according to a thickness of a first electron transport layer including ZnO in a light emitting device emitting green light.
FIG. 10 illustrates an efficiency according to a thickness of a first electron transport layer including ZnO in a light emitting device emitting blue light.
FIG. 11 illustrates a schematic cross-section of a display device including a light emitting device according to an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the X, Y, and Z - axes, and may be interpreted in a broader sense. For example, the DR1-axis, the DR2-axis, and the DR3-axis may be perpendicular to one another, or may represent different directions that are not perpendicular to one another. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Hereinafter, a light emitting device and a display device including the light-emitting device according to an embodiment of the disclosure will be described in detail with reference to the drawings.

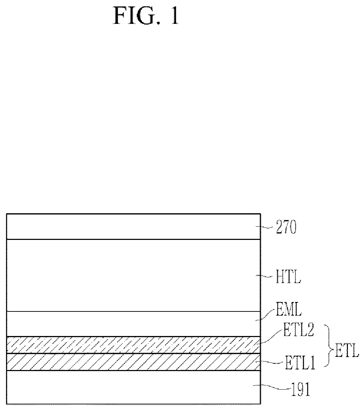

FIG. 1 illustrates a schematic cross-section of a light emitting device according to an embodiment. Referring to FIG. 1, the light emitting device may include a first electrode 191, an electron transport layer ETL, an emission layer (or light emitting layer) EML, a hole transport layer HTL, and a second electrode 270. The light emitting device may have a structure in which an electron transport layer is positioned between the first electrode 191 and the emission layer EML, and a hole transport layer is positioned between the second electrode 270 and the emission layer EML. This structure may have an advantage in that a material for forming a hole transport layer is freely selected by forming the hole transport layer after formation of the emission layer.

The first electrode 191 and the second electrode 270 may each include a conductive oxide such as an indium tin oxide (ITO), an indium zinc oxide (IZO), a zinc tin oxide (ZTO), a copper indium oxide (CIO), a copper zinc oxide (CZO), a gallium zinc oxide (GZO), an aluminium zinc oxide (AZO), a tin oxide (SnO₂), a zinc oxide (ZnO), or a combination thereof, or a conductive polymer such as calcium (Ca), ytterbium (Yb), aluminium (Al), silver (Ag), magnesium (Mg), samarium (Sm), titanium (Ti), gold (Au) or an alloy thereof, graphene, a carbon nanotube, or PEDOT:PSS. However, the first electrode 191 and the second electrode 270 are not limited thereto, and may be formed in a stacked structure of two or more layers.

In an embodiment, the first electrode 191 may be a reflective electrode, and the second electrode 270 may be a transflective electrode. Light generated from an emission layer EML may be reflected by the first electrode 191, which is a reflective electrode, and may be resonated between the second electrode 270, which is a transflective electrode, and the first electrode 191 to be amplified. The resonated light may be reflected from the first electrode 191 to be emitted to an upper surface of the second electrode 270.

In another example, the second electrode 270 may be a reflective electrode, and the first electrode 191 may be a transflective electrode. Light generated from an emission layer EML may be reflected by the second electrode 270, which is a reflective electrode, and may be resonated between the first electrode 191, which is a transflective electrode, and the second electrode 270 to be amplified. The resonated light may be reflected from the second electrode 270 to be emitted to an upper surface of the first electrode 191.

The hole transport layer HTL may include at least one of m-MTDATA, TDATA, 2-TNATA, NPB(NPD), β-NPB, TPD, Spiro-TPD, Spiro-NPB, Methylated-NPB, TAPC, HMTPD, TCTA(4,4',4"-tris( N-carbazolyl)triphenylamine), Pani/DBSA (Polyaniline/Dodecylbenzenesulfonic acid), PEDOT/PSS (Poly(3,4-ethylenedioxythiophene)/Poly(4-styrenesulfonate))), Pani/CSA (Polyaniline/Camphor sulfonic acid), or PANI/PSS (Polyaniline/Poly(4-styrenesulfonate)). In another example, the hole transport layer may include an alkali metal halide or an alkaline earth metal halide.

The emission layer EML may include an organic material or an inorganic material. The emission layer may include quantum dots. For example, the quantum dots may include at least one of Zn, Te, Se, Cd, In, or P. The quantum dots may include a core including at least one of Zn, Te, Se, Cd, In, or P, and a shell positioned at a portion of the core and having a different composition from that of the core.

For example, the quantum dots may be selected from a group II-VI compound, a group I-III-VI compound, a group III-V compound, a group IV-VI compound, a group IV element, and a group IV compound and a combination thereof.

The quantum dots may be selected from a Group II-VI compound which is selected from a two-element compound selected from CdSe, CdTe, CdS, ZnS, ZnSe, ZnTe, ZnO, HgS, HgSe, HgTe, MgSe, MgS, and a mixture thereof; a three-element compound selected from CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; and a four-element compound selected from HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof.

The quantum dot may be selected from a three-element compound selected from AgInS, CuInS, AgGaS, and CuGaS, which are a Group I-III-VI compound, and a mixture thereof or four-element compounds such as AgInGaS and CuInGaS.

The Group III-V compound may be selected from a two-element compound selected from GaN, GaP, GaAs, GaSb, AlN, AlP, AlAs, AlSb, InN, InP, InAs, InSb, and a mixture thereof; a three-element compound selected from GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a mixture thereof; and a four-element compound selected from GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof. For example, the Group III-V compound may further include a Group II metal (e.g., InZnP), and may be selected from these compounds.

The Group IV-VI compound may be selected from a two-element compound selected from SnS, SnSe, SnTe, PbS, PbSe, PbTe, and a mixture thereof; a three-element compound selected from SnSeS, SnSeTe, SnSTe, PbSeS, PbSeTe, PbSTe, SnPbS, SnPbSe, SnPbTe, and a mixture thereof; and a four-element compound selected from SnPbSSe, SnPbSeTe, SnPbSTe, and a mixture thereof. The Group IV element may be selected from Si, Ge and a mixture thereof, and the Group IV compound may be a two-element compound selected from SiC, SiGe, and a mixture thereof.

The electron transport layer ETL may include a first electron transport layer ETL1 and a second electron transport layer ETL2.

The first electron transport layer ETL1 may include a first electron transport material. The first electron transport material may include at least one metal oxide selected from ZnO, TiO₂, WO₃, and SnO₂ and/or at least one of ZnO, TiO₂, WO₃, and SnO₂ doped with Mg, Y, Li, Ga, and Al. A thickness of the first electron transport layer ETL1 may be in a range of about 85 nm to about 250 nm. In the case that a thickness of the first electron transport layer ETL1 is smaller than about 85 nm, in order to form an appropriate thickness of the entire electron transport layer ETL, a thickness of the second electron transport layer ETL2 having a low electron mobility increases, and thus there is a problem in that an electron mobility decreases. For example, in the case that the thickness of the first electron transport layer ELT1 is greater than about 250 nm, the thickness of the second electron transport layer ETL2 may decrease, making it difficult to control thin film formation and deteriorating thin film uniformity.

The second electron transport layer ETL2 may include a second electron transport material. The second electron transport material may include at least one metal oxide selected from ZnO, TiO₂, WO₃, and SnO₂ and/or at least one of ZnO, TiO₂, WO₃, and SnO₂ doped with Mg, Y, Li, Ga, and Al.

For example, a thickness of the second electron transport layer ETL2 may be in a range of about 20 nm to about 40 nm. In the case that the thickness of the second electron transport layer ETL2 is smaller than about 20 nm, there may be a problem in surface roughness and uniformity in the forming the thickness, and in the case that the thickness is greater than about 40 nm, there may be a problem of deterioration in characteristics due to a decrease in charge mobility.

For example, an electron mobility of the first electron transport layer ETL1 may be faster than an electron mobility of the second electron transport layer ETL2. For example, the electron mobility of the first electron transport layer ETL1 may be in a range of about 5 x 10⁻³ to about 5 x 10⁻⁵ cm²V⁻¹S⁻¹, and the electron mobility of the second electron transport layer ETL2 may be in a range of about 1 x 10⁻³ to about 1 x 10⁻⁵ cm²V⁻¹S⁻.

For example, the thickness of the first electron transport layer ETL1 may be greater than the thickness of the second electron transport layer ETL2. This is because the electron mobility of the first electron transport layer ETL1 is faster than the electron mobility of the second electron transport layer ETL2. Thus, the thickness of the first electron transport layer ETL1 may be greater than the thickness of the second electron transport layer ETL2 to improve the electron injection.

For example, a conduction band of the second electron transport layer ETL2 may be positioned between a conduction band of the first electron transport layer ETL1 and a conduction band of quantum dots included in the emission layer. This is also a structure for improved electron injection.

The light emitting device according to an embodiment may have a secondary resonance structure. Resonance indicates a phenomenon in which the speed and pressure of an object's vibration are amplified in the case that it is subjected to the action of an external force having the same frequency as its own natural frequency, and a resonance structure indicates a structure that utilizes constructive interference of waves by adjusting the thickness for this amplification phenomenon. Resonance may be a primary resonance or a secondary resonance according to a thickness of an object to be resonated. For the primary resonance, a thickness of a lower portion of an emission layer must be thin, but it is difficult to form it with a thin thickness, and thus it may be formed as a secondary resonance structure according to the disclosure. For example, the thickness of the first electron transport layer ETL1 may be in a range of about 85 nm to about 250 nm, the thickness of the second electron transport layer ETL2 may be in a range of about 20 nm to about 40 nm, the thickness of the emission layer EML may be in a range of about 10 nm to about 30 nm, and the thickness of the hole transport layer HTL may be in a range of about 20 nm to about 40 nm. For example, according to an embodiment, the light emitting device may further include a hole injection layer positioned between the hole transport layer HTL and the second electrode 270, and the hole injection layer may have a thickness of about 10 nm to about 30 nm.

Since the light emitting device having the above structure has a two-layer electron transport layer structure, the thickness for the secondary resonance structure may be readily adjusted. Accordingly, electron-hole balance may be improved, and device characteristics may be improved.

Hereinafter, an effect of the light emitting device according to an embodiment will be described.

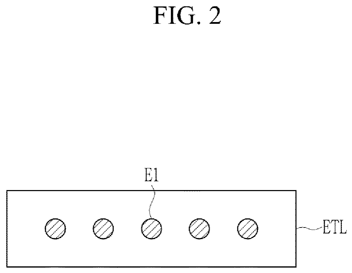

Experimental Example 1 includes a light emitting device including an electron transport layer ETL including only a first electron transport material E1. The electron transport layer ETL of Experimental Example 1 is illustrated in FIG. 2.

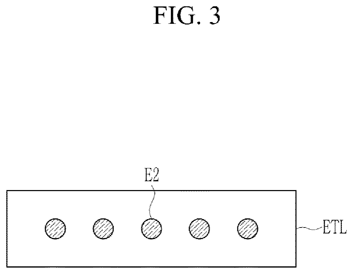

Experimental Example 2 includes a light emitting device including an electron transport layer ETL including only a second electron transport material E2. The electron transport layer ETL of Experimental Example 2 is illustrated in FIG. 3.

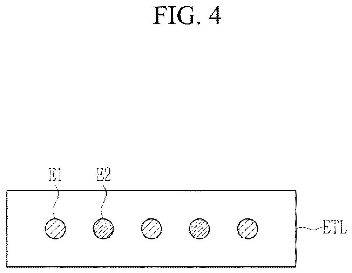

Experimental Example 3 includes a light emitting device including an electron transport layer ETL in which the first electron transport material E1 and the second electron transport material E2 are mixed and positioned as a single layer. The electron transport layer ETL of Experimental Example 3 is illustrated in FIG. 4.

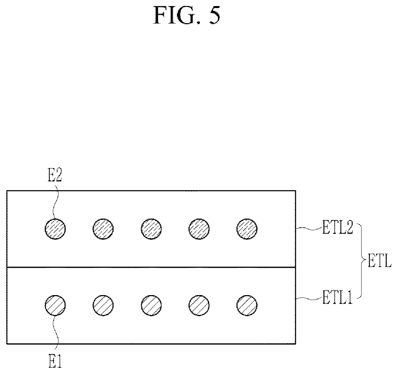

Experimental Example 4 includes a light emitting device including a first electron transport layer ETL1 including the first electron transport material E1 and a second electron transport layer ETL2 including the second electron transport material E2 according to an embodiment. The electron transport layer ETL of Experimental Example 4 is illustrated in FIG. 5.

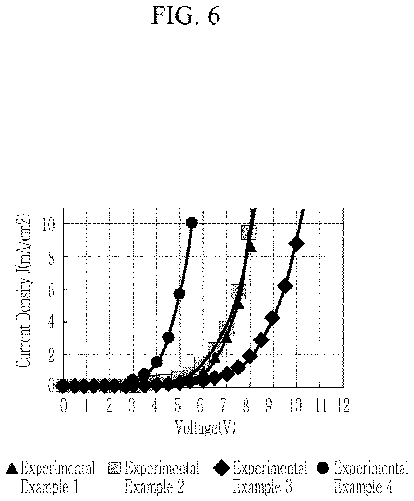

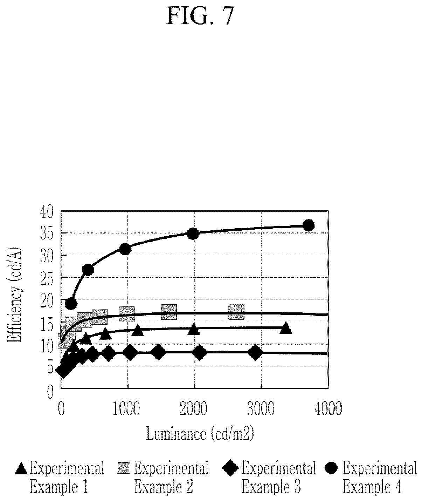

Table 1 below shows the driving voltage and efficiency of the light emitting device including the electron transport layer measured according to Experimental Examples 1 to 4, i.e., the embodiments of FIG. 2 to FIG. 5. For example, the V-J graphs of Experimental Examples 1 to 4 are shown in FIG. 6, and the efficiency is shown in FIG. 7.

In FIG. 2 to FIG. 5, for better comprehension and convenience of description, the first electron transport material E1 and the second electron transport material E2 are shown in the form of particles, but embodiments are not limited thereto, and the first electron transport material E1 or the second electron transport material E2 may be positioned throughout the electron transport layer.

**(Table 1)**

| | Driving voltage (@ 5mA/cm²) | Efficiency (cd/A) |
|---|---|---|
| Experimental Example 1 | 7.4 V | 13.5 |
| Experimental Example 2 | 7.3 V | 17.1 |
| Experimental Example 3 | 9.2 V | 8.1 |
| Experimental Example 4 | 4.9 V | 34.4 |

Referring to Table 1 and FIG. 6 and 7, the driving voltage of Experimental Example 4 may be decreased and the efficiency of Experimental Example 4 may be significantly increased as compared to other experimental examples (e.g., Experimental Example 1, Experimental Example 2, and Experimental Example 3). As described above, in Experimental Example 4, the first electron transport layer ETL1 including the first electron transport material E1 and the second electron transport layer ETL2 including the second electron transport material E2 may be respectively formed. For example, FIGS. 6 and 7 show that a light emitting efficiency of the light emitting device including the first electron transport layer and the second electron transport layer may be excellent or improved. After producing the emission irradiation of Experimental Examples 5 to 8 under the same conditions as in Table 2 below, a driving voltage and efficiency may be measured and shown in Table 2.

**(Table 2)**

| | Electron transport layer | | | Emission layer | Hole transport layer | Hole injection layer |
|---|---|---|---|---|---|---|
| Experimental Example 5 | ZnO | | ZnMgO | 200 Å | 300 Å | 200 Å |
| | 1600 Å | | 350 Å | | | |
| Experimental Example 6 | ZnO | | Mix | | | |
| | 1450 Å | | 500 Å | | | |
| Experimental Example 7 | ZnO | Mix | ZnMgO | | | |
| | 1200 Å | 400 Å | 350 Å | | | |
| Experimental Example 8 | Mix | | | | | |
| | 1950 Å | | | | | |

In Table 2, Experimental Example 5, ZnO may be formed to have a thickness of about 160 nm as a first electron transport layer, and ZnMgO may be formed to have a thickness of about 35 nm as a second electron transport layer. In Experimental Example 6, ZnO may be formed to have a thickness of about 145 nm as the first electron transport layer, and a mixture of ZnO and ZnMgO may be formed to have a thickness of about 50 nm as the second electron transport layer.

In Experimental Example 7, ZnO may be formed to have a thickness of about 120 nm as a first electron transport layer, ZnMgO may be formed to have a thickness of about 35 nm as a second electron transport layer, and a mixed layer of ZnO and ZnMgO may be formed to have a thickness of about 40 nm between the first electron transport layer and the second electron transport layer.

In Experimental Example 8, an electron transport layer, in which ZnO and ZnMgO are mixed, may be formed to have a thickness of about 195 nm as a single layer.

In each experimental example, the thickness of the emission layer may be about 20 nm, the thickness of the hole transport layer may be about 30 nm, and the thickness of the electron injection layer may be about 20 nm. The emission layer may include quantum dots emitting green light.

Table 3 shows driving voltage and efficiency measurement results of Experimental Examples 5, 6, 7, and 8.

**(Table 3)**

| | @ 5mA/cm² | Required luminance (1840 nit) | | | | | | |
|---|---|---|---|---|---|---|---|---|
| | Driving voltage (V) | Driving voltage (V) | Efficiency (Cd/A) | E.Q.E (External Quantum Efficiency) | Half height | CIE_x | CIE_y | Ammx (nm) |
| Experimental Example 5 | 4.9 | 4.9 | 34.4 | 9.1 | 32 | 0.253 | 0.719 | 536 |
| Experimental Example 6 | 7.4 | 7.4 | 13.5 | 3.5 | 31 | 0.269 | 0.709 | 539 |
| Experimental Example 7 | 7.3 | 7.3 | 17.1 | 4.6 | 32 | 0.246 | 0.723 | 535 |
| Experimental Example 8 | 9.2 | 9.2 | 8.1 | 2.3 | 37 | 0.213 | 0.734 | 531 |

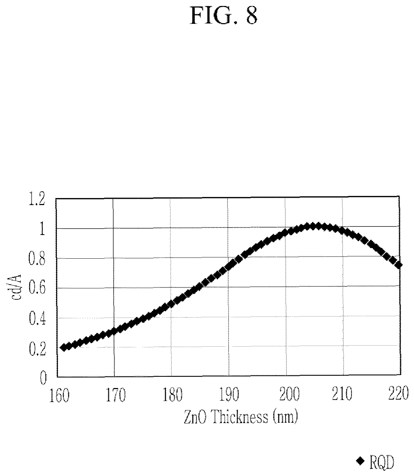

Referring to the Table 3, the driving voltage of Experimental Example 5 may be the smallest, and the efficiency may be the highest. For example, the efficiency of the light emitting device, in which the first electron transport layer and the second electron transport layer are formed of each material, may be the highest. An optimal thickness of the first electron transport layer may vary according to a wavelength of light emitted. FIG. 8 illustrates an efficiency according to a thickness of a first electron transport layer including ZnO in a first light emitting device emitting red light. Referring to FIG. 8, in the case that the first light emitting device emits red light, the optimum thickness of the first electron transport layer may be in a range of about 190 nm to about 220 nm.

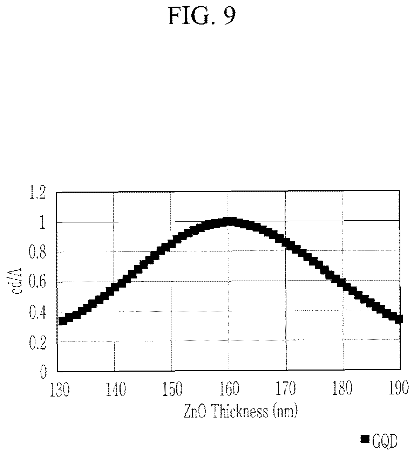

FIG. 9 illustrates an efficiency according to a thickness of a first electron transport layer including ZnO in a second light emitting device emitting green light. Referring to FIG. 9, in case that the second light emitting device emits green light, the optimum thickness of the first electron transport layer may be in a range of about 145 nm to about 175 nm.

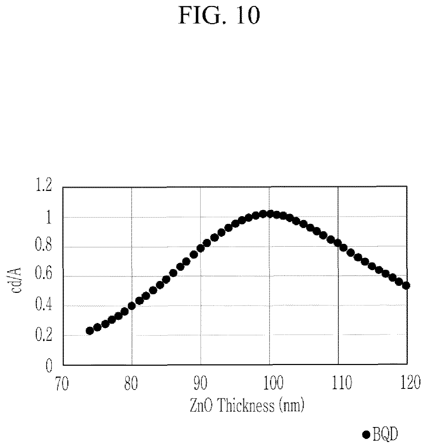

FIG. 10 illustrates an efficiency according to a thickness of a first electron transport layer including ZnO in a third light emitting device emitting blue light. Referring to FIG. 10, in case that the third light emitting device emits blue light, the optimum thickness of the first electron transport layer may be in a range of about 85 nm to about 115 nm.

For example, the optimum thickness of the first electron transport layer may be different according to the emitted light. Accordingly, even within a single display device, a thickness of the first electron transport layer for each light emitting device may be different according to light emitted by each light emitting device. In a display device including the red light emitting device, the green light emitting device, and the blue light emitting device, the thickness of the first electron transport layer included in each light emitting device may be different. For example, the thickness of the first electron transport layer of the red light emitting device may be greater than that of the first electron transport layer of the blue light emitting device.

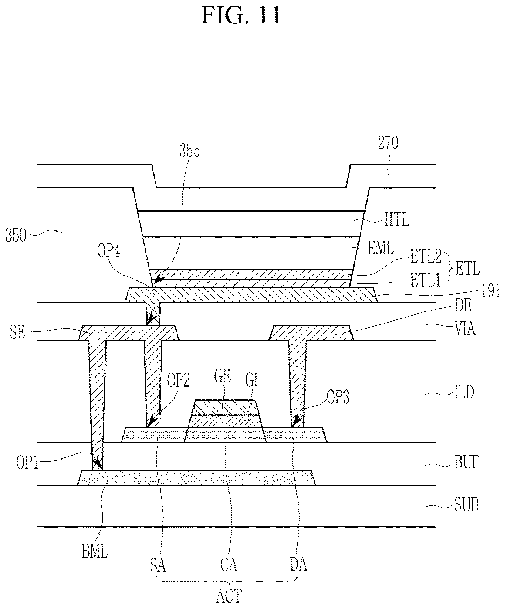

Hereinafter, a display device including a light emitting device according to an embodiment will be described with reference to the drawings. FIG. 11 illustrates a schematic cross-section of a display device including a light emitting device according to an embodiment. FIG. 11 illustrates a portion of a cross section for convenience of description, but embodiments are not limited thereto.

Referring to FIG. 11, the display device may include a substrate SUB. The substrate SUB may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, or cellulose acetate propionate. The substrate SUB may be a rigid substrate or a flexible substrate capable of bending, folding, rolling, or the like. The substrate SUB may be a single layer or a multilayer. In the substrate SUB, at least one base layer including a polymer resin sequentially stacked and at least one inorganic layer may be alternately stacked with each other.

A light blocking layer BML may be positioned on the substrate SUB. The light blocking layer BML may include aluminium (Al), silver (Ag), magnesium (Mg), gold (Au), nickel (Ni), chromium (Cr), calcium (Ca), molybdenum (Mo), titanium (Ti), tungsten (W), and/or copper (Cu) and a metal oxide, and may have a single-layered structure or a multi-layered structure including the same materials.

A buffer layer BUF may be positioned on the light blocking layer BML. The buffer layer BUF may include a silicon oxide (SiOₓ), a silicon nitride (SiNₓ), a silicon oxynitride (SiOₓN_{y}), or amorphous silicon (Si).

The buffer layer BUF may include a first opening OP1 overlapping the light blocking layer BML. In the first opening OP1, a source electrode SE may be connected to the light blocking layer BML.

A semiconductor layer ACT may be disposed on the buffer layer BUF. The semiconductor layer ACT may include polycrystalline silicon. The semiconductor layer ACT may include a channel area CA overlapping the gate electrode GE, and a source area SA and a drain area DA positioned at opposite sides of the channel area CA.

A gate insulating layer GI may be disposed on the semiconductor layer ACT. The gate insulating layer GI may include a silicon oxide (SiOₓ), a silicon nitride (SiNₓ), or a silicon oxynitride (SiOₓN_{y}), and may have a single-layered structure or a multi-layered structure including the same material.

The gate insulating layer GI may be positioned to overlap the channel area CA of the semiconductor layer ACT. A gate conductive layer including a gate electrode GE may be positioned on the gate insulating layer GI. The gate conductive layer may include molybdenum (Mo), aluminium (Al), copper (Cu), titanium (Ti), and a metal oxide, and may have a single-layered structure or a multi-layered structure including the same material.

The gate electrode GE may be formed in a same process as the gate insulating layer GI to have a same planar shape. The gate electrode GE may be positioned to overlap the semiconductor layer ACT in a direction that is perpendicular to a surface of the substrate SUB.

An interlayer insulating layer ILD may be disposed on the semiconductor layer ACT and the gate electrode GE. The interlayer insulating layer ILD may include a silicon oxide (SiOₓ), a silicon nitride (SiNₓ), or a silicon oxynitride (SiOₓN_{y}), and may have a single-layered structure or a multi-layered structure including the same material. In the case that the interlayer insulating layer ILD has a multi-layered structure including a silicon nitride and a silicon oxide, a layer including a silicon nitride may be disposed to be closer to the substrate SUB than a layer including a silicon oxide.

The interlayer insulating layer ILD may include a first opening OP1 overlapping the light blocking layer BML, a second opening OP2 overlapping the source area SA of the semiconductor layer ACT, and a third opening OP3 overlapping the drain area DA.

A data conductive layer including the source electrode SE and the drain electrode DE may be positioned on the interlayer insulating layer ILD. The data conductive layer may include aluminium (Al), silver (Ag), magnesium (Mg), gold (Au), nickel (Ni), chromium (Cr), calcium (Ca), molybdenum (Mo), titanium (Ti), tungsten (W), and/or copper (Cu) and a metal oxide thereof, and may have a single-layered structure or a multi-layered structure including the same material.

The source electrode SE may contact the light blocking layer BML in the first opening OP1, and may contact the source area SA of the semiconductor layer ACT in the second opening OP2. The drain electrode DE may contact the drain area DA of the semiconductor layer ACT in the third opening OP3.

An insulating layer VIA may be positioned on the data conductive layer. The insulating layer VIA may include an organic insulating material such as a general purpose polymer, e.g., polymethylmethacrylate (PMMA) or polystyrene (PS), a polymer derivative having a phenolic group, an acrylic polymer, an imide polymer, a polyimide, a siloxane polymer, etc.

The insulating layer VIA may have a fourth opening OP4 overlapping the source electrode SE. A first electrode 191 may be positioned on the insulating layer VIA. An electron transport layer ETL, an emission layer EML, a hole transport layer HTL, and a second electrode 270 may be positioned on the first electrode 191. The electron transport layer ETL, the emission layer EML, the hole transport layer HTL and the second electrode 270 on the first electrode 191 may form a light emitting device, and thus a detailed description of the light emitting device is omitted as it is the same as described above.

For example, the electron transport layer ETL may include a first electron transport layer ELT1 including a first electron transport material and a second electron transport layer ETL2 including a second electron transport material. A detailed description thereof is the same as described above.

In concluding the detailed description, those skilled in the art will appreciate that many variations and modifications may be made to the embodiments without substantially departing from the principles and spirit and scope of the disclosure. Therefore, the disclosed embodiments are used in a generic and descriptive sense only and not for purposes of limitation.

## Claims

1. A light emitting device comprising:
a first electrode that is a reflective electrode;
a first electron transport layer disposed on the first electrode;
a second electron transport layer disposed on the first electron transport layer;
an emission layer disposed on the second electron transport layer; and
a second electrode positioned on the emission layer, the second electrode is a transflective electrode, wherein
the first electron transport layer and the second electron transport layer include different metal oxides, and
a thickness of the first electron transport layer is greater than a thickness of the second electron transport layer.

2. The light emitting device of claim 1, wherein the first electron transport layer includes at least one of ZnO, TiO₂, WO₃, and SnO₂ and/or at least one of ZnO, TiO₂, WO₃, and SnO₂ doped with Mg, Y, Li, Ga, and Al.

3. The light emitting device of claim 1, wherein the second electron transport layer includes at least one of ZnO, TiO₂, WO₃, and SnO₂ and/or at least one of ZnO, TiO₂, WO₃, and SnO₂ doped with Mg, Y, Li, Ga, and Al.

4. The light emitting device of claim 1, wherein the thickness of the first electron transport layer is in a range of about 85 nm to about 250 nm.

5. The light emitting device of claim 1, wherein the thickness of the second electron transport layer is in a range of about 20 nm to about 40 nm.

6. The light emitting device of claim 1, wherein an electron mobility of the first electron transport layer is faster than an electron mobility of the second electron transport layer.

7. The light emitting device of claim 1, wherein an electron mobility of the first electron transport layer is about 5 x 10⁻³ cm²V⁻¹S⁻¹ to about 5 x 10⁻⁵ cm²V⁻¹S⁻¹.

8. The light emitting device of claim 1, wherein an electron mobility of the second electron transport layer is about 1 x 10⁻³ cm²V⁻¹S⁻¹ to about 1 x 10⁻⁵ cm²V⁻¹S⁻¹.

9. The light emitting device of claim 1, wherein light emitted from the emission layer is subjected to secondary resonance between the first electrode and the second electrode.

10. The light emitting device of claim 1, wherein a thickness of the emission layer is in a range of about 10 nm to about 30 nm.

11. The light emitting device of claim 1, further comprising:
a hole transport layer disposed between the emission layer and the second electrode,
wherein a thickness of the hole transport layer is in a range of about 10 nm to about 30 nm.

12. The light emitting device of claim 1, wherein
the first electron transport layer includes ZnO, and
the second electron transport layer includes ZnMgO.

13. A display device comprising:
a plurality of transistors positioned on a substrate; and
a plurality of light emitting devices electrically connected to the plurality of transistors, wherein
the plurality of light emitting devices include a first light emitting device, a second light emitting device, and a third light emitting device,
each of the plurality of light emitting devices includes:
a first electrode connected to the plurality of transistors;
a first electron transport layer disposed on the first electrode;
a second electron transport layer disposed on the first electron transport layer;
an emission layer disposed on the second electron transport layer;
a hole transport layer disposed on the emission layer; and
a second electrode disposed on the hole transport layer,
the first electron transport layer and the second electron transport layer include different metal oxides, and
a thickness of the first electron transport layer is greater than a thickness of the second electron transport layer.

14. The display device of claim 13, wherein the first electron transport layer includes at least one of ZnO, TiO₂, WO₃, and SnO₂ and/or at least one of ZnO, TiO₂, WO₃, and SnO₂ doped with Mg, Y, Li, Ga, and Al.

15. The display device of claim 13, wherein
the first light emitting device is configured to emit red light, and
the thickness of the first electron transport layer included in the first light emitting device is in a range of about 85 nm to about 250 nm.

16. The display device of claim 15, wherein
the second light emitting device is configured to emit blue light, and
the thickness of the first electron transport layer of the first light emitting device is greater than the thickness of the first electron transport layer of the second light emitting device.

17. The display device of claim 13, wherein the thickness of the second electron transport layer is in a range of about 20 nm to about 40 nm.

18. The display device of claim 13, wherein an electron mobility of the first electron transport layer is faster than an electron mobility of the second electron transport layer.

19. The display device of claim 13, wherein
the first electron transport layer includes ZnO, and
the second electron transport layer includes ZnMgO.

20. The display device of claim 13, wherein the first electrode is a reflective electrode, and the second electrode is a transflective electrode.
